# EUROPÄISCHE PATENTSCHRIFT

(11) **EP 3 544 055 B1**
(45) Veröffentlichungstag und Bekanntmachung des Hinweises auf die Patenterteilung: **07.07.2021**
(21) Anmeldenummer: 19161971.7
(22) Anmeldetag: 11.03.2019
(51) Int. Cl.: H01L 23/525, H01L 23/538, H03K 17/12, H02H 3/087, H05K 1/02, H05K 3/28

(54) **ELEKTRISCHE SCHALTVORRICHTUNG SOWIE VERFAHREN ZUR HERSTELLUNG EINER ELEKTRISCHEN SCHALTVORRICHTUNG**
ELECTRICAL SWITCHING APPARATUS AND METHOD FOR PRODUCING AN ELECTRICAL SWITCHING APPARATUS
DISPOSITIF DE COMMUTATION ÉLECTRIQUE, AINSI QUE PROCÉDÉ DE FABRICATION D'UN DISPOSITIF DE COMMUTATION ÉLECTRIQUE

(30) Priorität: 19.03.2018 DE 102018204180
(43) Veröffentlichungstag der Anmeldung: 25.09.2019
(73) Patentinhaber: LEONI Bordnetz-Systeme GmbH, 97318 Kitzingen (DE)
(72) Erfinder: Ionel, Butar, 310850 Arad (RO)
(74) Vertreter: FDST Patentanwälte

(56) Entgegenhaltungen:
- DE-U1-202016 101 991
- US-A- 5 880 016
- US-B1- 8 958 956

## Beschreibung

Die Erfindung betrifft eine elektrische Schaltvorrichtung sowie ein Verfahren zur Herstellung einer derartigen elektrischen Schaltvorrichtung.

Elektrische Schaltvorrichtungen sind in nahezu jeder elektrischen Schaltung und/oder jedem elektrischen Stromkreis zum Schalten von elektrischen Zustandsgrößen, insbesondere von Strömen angeordnet.

Häufig sind Schaltvorrichtungen auch als Sicherungsvorrichtungen eingesetzt.

Derartige Sicherungsvorrichtungen sind üblicherweise auch in Kraftfahrzeugen, beispielsweise innerhalb von Sicherungsboxen angeordnet. Die Sicherungsvorrichtungen weisen dabei üblicherweise Schmelzsicherungen auf, die auf einer Leiterplatte angeordnet sind oder in die Leiterplatte integriert sind.

Die anwendungsspezifische Dimensionierung der Schaltelemente, z.B. für unterschiedliche Kraftfahrzeuge und somit einer unterschiedlichen Anwendungsspezifik ist teilweise aufwändig und kostenintensiv.

Ausgehend hiervon liegt der Erfindung die Aufgabe zugrunde, eine elektrische Schaltvorrichtung anzugeben, die einfach anwendungsspezifisch konfigurierbar ist. Der Erfindung liegt weiterhin die Aufgabe zugrunde, ein Verfahren zur Herstellung einer elektrischen Schaltvorrichtung anzugeben.

Aus der US 8,958,956 B1 ist ein Batterie-Überwachungs-System mit einem Ausgangsschaltkreis beschrieben. Dieser Ausgangsschaltkreis weist zwei unterschiedliche Ausgänge auf, die jeweils über eine unterschiedliche Anzahl von parallel geschalteten IC's versorgt werden.

Die Aufgabe wird erfindungsgemäß gelöst durch eine elektrische Schaltvorrichtung mit den Merkmalen des Anspruchs 1 sowie durch ein Verfahren zur Herstellung einer Schaltvorrichtung mit den Merkmalen des Anspruchs 14. Vorteilhafte Ausgestaltungen, Weiterbildungen und Varianten sind Gegenstand der Unteransprüche.

Die im Hinblick auf die Schaltvorrichtung aufgeführten Vorteile und bevorzugten Ausgestaltungen sind sinngemäß auf das Verfahren zu übertragen und umgekehrt. Das Verfahren dient insbesondere der Herstellung der im Folgenden beschriebenen Schaltvorrichtung.

Die elektrische Schaltvorrichtung, die in einem Ausgangszustand eine Zusammenschaltung aus mindestens drei elektronischen Schaltzellen darstellt, weist in einem endkonfektionierten Zustand mehrere voneinander unabhängige elektronische Schalteinheiten, auch Schaltabschnitte genannt, zum Schalten jeweils eines Strompfades auf. D.h. jede der Schalteinheiten dient zum Schalten insbesondere genau eines Strompfades. Unter einem Ausgangszustand wird vorliegend ein Zustand der Schaltvorrichtung verstanden, in dem beispielsweise die mindestens drei Schaltzellen beispielsweise elektrisch miteinander verschaltet sind und speziell ein Zustand der Schaltvorrichtung, beispielsweise eine Zwischenstufe im Rahmen der Fertigung verstanden, den diese vor dem endkonfektionierten Zustand aufweist. Unter dem endkonfektionierten Zustand wird vorliegend ein Zustand der Schaltvorrichtung verstanden, in dem diese beispielsweise für eine anschließende Anwendung in einer Schaltung, beispielsweise zur elektrischen Versorgung eines Kraftfahrzeuges oder einer Sicherungsbox einbaufertig dimensioniert und eingerichtet ist.

Jede Schalteinheit weist zumindest eine Schaltzelle auf und zumindest eine Schalteinheit weist zumindest zwei Schaltzellen auf, die miteinander - wie im Ausgangszustand - miteinander verschaltet sind. Die Schaltzellen sind im Ausgangszustand elektrisch parallel zueinander geschaltet, so dass die miteinander verschalteten Schaltzellen der jeweiligen Schalteinheit im endkonfektionierten Zustand ebenfalls elektrisch parallel zueinander geschaltet sind.

Die elektronischen Schaltzellen weisen jeweils Halbleiterschaltelemente, zweckdienlicherweise Transistoren, beispielsweise Leistungs-MOSFETs (Leistungs-Metall-Oxid-Halbleiter-Feldeffekttransistor) auf. Insbesondere sind die Schaltzellen aus den Halbleiterschaltelementen gebildet. Allgemein handelt es sich bei den Schaltzellen um reversibel betätigbare Schaltelemente, die also zwischen einem leitenden und einem nicht leitenden Zustand hin und her geschaltet werden können. Die Schalteinheiten dienen beispielsweise zum normalen Schalten des Strompfades. Halbleiterschalter, insbesondere Transistoren haben sich hinsichtlich ihrer Schaltzeiten, ihrer geringen Baumaße im Vergleich zu leistungsgleichen Alternativbauteilen sowie ihrem Schaltvermögen in Bezug auf Stromwerte >50A als vorteilhaft erwiesen. Zur Anordnung der Halbleiterschaltelemente auf dem Träger werden herkömmliche Anordnungs- und Bestückungsverfahren herangezogen. Herkömmliche Anordnungs- oder Bestückungsverfahren sind beispielsweise eine Anordnung nach Art eines Surface-Mounted-Device (SMD) und/oder ein Pick and Place-Verfahren.

Alle Schaltzellen der Schalteinheiten sind auf einem gemeinsamen Träger angeordnet. Unter Träger wird vorliegend allgemein eine Leiterplatine, ein Wafer, also eine Grundplatte oder ähnliche Systeme zur Anordnung elektronischer Bauelemente und/oder ein "Die", also ein Teil eines Wafers, verstanden.

In dem Ausgangszustand sind zunächst alle Schaltzellen untereinander über elektrische Leiter, beispielsweise mittels eines Bonddrahtes und/oder einer Lötbahn und/oder einer Leiterbahn und/oder ähnliche Systeme verbunden. Unter Leiter wird vorliegend allgemein eine elektrische Verbindung verstanden. Der Begriff Leiter wird ohne Beschränkung der Allgemeinheit nachfolgend für eine solche elektrische Verbindung verwendet. Mit anderen Worten: Die sich im Ausgangszustand befindliche Schaltvorrichtung kann vorliegend auch als ein einheitliches, standardisiertes Zwischenprodukt im Rahmen der Fertigung angesehen werden. Für unterschiedliche anwendungsspezifische, endkonfektionierte Zustände wird also das gleiche Zwischenprodukt verwendet.

Zur Ausbildung der Schalteinheiten für den endkonfektionierten Zustand sind bestimmte vorgegebene Leiter zwischen Schalteinheiten, bevorzugt zwischen benachbarten Schalteinheiten, unterbrochen. Während der Fertigung erfolgt also ein Trennen der bestimmten Leiter, insbesondere mechanisch (galvanisch) und irreversibel. Dies erfolgt beispielsweise mittels eines Strahlwerkzeugs, insbesondere mittels eines Lasers (Laser Cutting)

Durch dieses Vorgehen sind daher im endkonfektionierten Zustand noch Teilstücke der bestimmten Leiter auf dem Träger enthalten, die jedoch nicht mehr elektrisch miteinander verbunden sind. Die Teilstücke sind also nach Art von Leiterenden ausgebildet.

Durch eine Aufteilung der Schaltzellen in eine Anzahl an Schalteinheiten, ist die Schaltvorrichtung individuell und somit insbesondere anwendungsspezifisch aus dem Zwischenprodukt konfigurierbar. Beispielsweise weist eine Schaltvorrichtung zehn Schaltzellen auf. Diese sind beispielsweise in fünf Schalteinheiten mit jeweils zwei Schaltzellen aufteilbar. Hierbei sind dann die Leiter zwischen zwei aufeinander folgenden Schaltzellen unterbrochen.

Weiterhin ist in dieser Ausgestaltung der Vorteil zu sehen, dass im Rahmen einer Fertigung der Schaltvorrichtung zunächst sich im Ausgangszustand befindliche und vor allem einheitliche Schaltvorrichtungen gefertigt werden, die anschließend zum Erreichen des endkonfektionierten Zustands anwendungsspezifisch konfigurierbar sind. Es kann somit auf eine aufwändige und kostenintensive Einzelfertigung von Schaltvorrichtungen verzichtet werden, da die endkonfektionierten Schaltvorrichtungen aus einem gleichen und einheitlichen Zwischenprodukt konfiguriert werden. Weiterhin werden hierdurch die Abläufe des Fertigungsprozesses deutlich optimiert.

Es werden daher für unterschiedliche Endkonfektionierungen, z.B. für unterschiedliche Varianten eines Kraftfahrzeuges oder für unterschiedliche Modellbaureihen die gleichen, identischen Zwischenprodukte verwendet. Erfindungsgemäß wird daher in bevorzugter Ausgestaltung ein Set an endkonfektionierten Schaltvorrichtungen erhalten, die individuell konfiguriert sind und sich voneinander unterscheiden. Die Schalvorrichtungen weisen jedoch alle den gleichen Träger mit der gleichen Anzahl an Schaltzellen auf. Mit anderen Worten: Die Schaltvorrichtungen weisen im endkonfektionierten Zustand bevorzugt eine gleiche Geometrie, eine gleiche Anzahl an Schaltzellen auf; lediglich die Verdrahtung der Schaltzellen untereinander ist unterschiedlich.

Die in einer Schalteinheit parallel geschalteten Schaltzellen dienen zum gemeinsamen Schalten genau eines Strompfades. Durch die Parallel-Schaltung teilt sich die zu schaltenden Leistung / der zu schaltende Strom auf die beiden Schaltzellen auf. Durch die einfache Konfektionierbarkeit können problemlos Schalteinheiten zum Schalten von unterschiedlich hohen Strömen durch eine entsprechende Anzahl von Schaltzellen innerhalb der jeweiligen Schalteinheit eingestellt werden. Dadurch lässt sich die Schaltvorrichtung leicht an unterschiedliche Anforderungen anpassen, so dass also ein Schalten von Strompfaden mit unterschiedlichen Lastströmen problemlos ermöglicht ist. Die Schaltvorrichtung lässt sich daher individuell für unterschiedliche Bordnetz-Anforderungen und Strukturen anpassen. Dies wird durch eine individuelle Trennbarkeit der einzelnen parallel geschalteten Schaltzellen ermöglicht, so dass sich unterschiedliche Konfigurationen erzeugen lassen, bei denen sich die Anzahl der parallel geschalteten Schaltzellen frei konfigurieren lässt. Auf diese Weise lassen sich Schalteinheiten mit unterschiedlichen Parameter, wie beispielsweise Absicherungsparametern (maximaler Strom) frei konfigurieren.

Der Träger ist insbesondere als ein gemeinsamer Träger ausgebildet. D.h., alle Schaltzellen sind auf einem gemeinsamen Träger, beispielsweise nach Art einer integrierten Schaltung angeordnet sind. Die Schaltzellen sind hierbei vorzugsweise nach Art eines Array und hardwaretechnisch seriell nacheinander über die Leiter zu einer Kette verbunden. Sie sind daher linienartig angeordnet, weisen also eine Linientopologie auf. Alternativ weisen die Schaltzellen eine Matrix-Anordnung auf. Grundsätzlich ist die hardwaretechnische, also örtliche Anordnung der Schaltzellen nicht auf eine Topologie beschränkt. Vielmehr sind im Hinblick auf eine anwendungsspezifische Konfiguration verschiedene hardwaretechnische Ausgestaltungen hinsichtlich Anzahl und Position der Schaltzellen auf dem Träger denkbar.

Im endkonfektionierten Zustand sind hierbei lediglich die Leiter mechanisch unterbrochen, nicht jedoch der Träger. Hierdurch ist die Schaltvorrichtung lediglich als ein Bauteil ausgebildet, was einbaufreundlich ist. Bei dem Bauteil handelt es sich daher insbesondere um eine mit den einzelnen Schaltzellen bestückte (Leiter-) Platte.

Zweckdienlicherweise ist jede Schaltzelle zum Schalten eines festgelegten, vorgegebenen maximalen Stromwerts, beispielsweise im Bereich von 1A bis 10A, speziell z.B. 5A, ausgelegt. Vorzugsweise ist der vorgegebene maximale Stromwert jeder Schaltzelle identisch. Hierdurch wird eine Konfiguration der Schaltvorrichtung deutlich vereinfacht. Bezugnehmend auf das bereits zuvor genannte Beispiel, bei dem zehn Schaltzellen in fünf Schalteinheiten mit je zwei Schaltzellen unterteilt sind, ist somit beispielsweise jede Schalteinheit zu einem Schalten eines elektrischen Stromes mit einem Wert von bis zu 10A ausgelegt. Die beispielhaft genannte Schaltvorrichtung ist somit insgesamt zum Schalten eines Stromes mit einem Wert von bis zu 50A ausgebildet. Grundsätzlich sind jedoch auch andere Aufteilungen der Schalteinheiten und somit der Schaltvorrichtung denkbar.

Bevorzugt weist zumindest eine der Schalteinheiten mehrere, insbesondere zumindest zwei parallel geschaltete Schaltzellen auf. Hierdurch wird erreicht, dass ein durch eine Schaltzelle fließender Gesamtstrom, beispielsweise mit einem Wert von 10A, durch die Parallelschaltung der Schaltzellen aufgeteilt wird. D.h. eine Schaltzelle muss vorliegend jeweils lediglich für ein Schalten eines Stromes mit einem Wert von 5A ausgelegt sein. Hierdurch wird eine "Einzelstromanforderung" an eine Schaltzelle und die damit verbundenen Kosten reduziert.

In diesem Zusammenhang weist die Schaltvorrichtung in einer zweckdienlichen Weiterbildung mehrere Schalteinheiten auf, die eine unterschiedliche Zahl an Schaltzellen aufweisen. Beispielsweise ist eine Schaltvorrichtung mit insgesamt zehn Schaltzellen derart konfigurierbar, dass eine erste Schalteinheit vier Schaltzellen aufweist, eine zweite Schalteinheit fünf Schaltzellen und eine dritte Schalteinheit folglich lediglich eine Schaltzelle aufweist. Der Vorteil dieser Weiterbildung ist in der bereits genannten individuellen und anwendungsspezifischen Konfigurierbarkeit der Schaltvorrichtung auf Basis einer standardisierten Schaltvorrichtung zu sehen.

Alternativ oder ergänzend weist die Schaltvorrichtung zusätzliche Schaltzellen als Blindzellen auf. Unter Blindzellen werden vorliegend speziell Schaltzellen verstanden, die im endkonfektionierten und insbesondere eingebauten Zustand der Schaltvorrichtung nicht an einen Strompfad angeschlossen sind. Mit andere Worten: Es werden also nur die Schaltzellen des einheitlichen Zwischenproduktes angeschlossen und somit auch verwendet, die für eine jeweilige anwendungsspezifische Konfiguration notwendig sind. Dies erschwert zudem ein "Reverse Engineering" zu Nachbauzwecken.
Die Halbleiterschaltelemente weisen allgemein unterschiedliche Arten von Anschlüssen auf, in der Regel zumindest einen quellenseitigen Anschluss, einen lastseitigen Anschluss sowie einen Steueranschluss. Bei einem (MOS)FET sind dies z.B. die Anschlüsse Source, Drain sowie Gate. Im Ausgangszustand sind vorzugsweise alle Anschlüsse gleicher Art der verschiedenen Schaltzellen miteinander elektrisch leitend über Leiter verbunden. Beim Konfektionieren werden dann die Leiter zwischen zwei Schaltzellen zur Ausbildung der Schalteinheiten getrennt. Beispielsweise werden dabei alle Arten von Anschlüssen getrennt. Alternativ bleibt eine Anschlussart, insbesondere die quellenseitige Anschlüsse miteinander verbunden.

Gemäß dieser Ausgestaltung sind die Halbleiterschaltelemente mit zumindest einem Anschluss an ein gemeinsames Potential, beispielsweise das Massepotential angeschlossen. Mit anderen Worten: Weisen die Schaltzellen beispielsweise jeweils MOSFETs auf, so ist vorliegend zumindest jeweils ein Anschluss der MOSFETs ausgewählt aus Drain, Source oder Gate an ein gemeinsames Potential angeschlossen. Insbesondere ist ein Anschluss ausgewählt aus Drain oder Source an ein gemeinsames Potential, beispielsweise dem Massepotential angeschlossen. Der jeweils andere Anschluss ist vorliegend mit dem zu schaltenden Strompfad verbunden. Der Gate-Anschluss ist vorliegend beispielsweise an eine Gate-Steuereinheit (Gate-Treiber) angeschlossen, die derart eingerichtet ist, dass sie die jeweiligen Halbleiterschalter über den Gate-Anschluss steuert, also die Halbleiterschalter öffnet oder schließt.

Gemäß einer zweckdienlichen Weiterbildung sind die Halbleiterschaltelemente mit zumindest einem Anschluss an unterschiedliche Potentiale, beispielsweise an unterschiedliche Massepotentiale angeschlossen. Mit anderen Worten: Weisen die Schaltzellen beispielsweise jeweils MOSFETs auf, so ist vorliegend zumindest jeweils ein Anschluss, beispielsweise zweier MOSFETs, ausgewählt aus Drain, Source oder Gate an unterschiedliche Potentiale angeschlossen.

Bevorzugt ist die Schaltvorrichtung als eine Sicherungsvorrichtung ausgebildet. Die Schaltvorrichtung dient somit einer Absicherung der angeschlossenen Strompfade. Hierzu wird ein jeweiliger Strompfad beispielsweise bei einem auftretenden oder drohenden Überstrom mittels der Schaltzellen getrennt. Hierzu werden die einzelnen elektronischen Schaltenheiten und Schaltzellen geeignet angesteuert, so dass sie von einem leitenden Schaltzustand in einen nicht leitenden Schaltzustand übergehen. Der Überstrom wird in geeigneter Weise erfasst, beispielsweise über ein in den Strompfad geschaltetes Strommesselement oder auch durch eine Steuereinheit. Vorzugsweise ist diese Sicherungsfunktion neben einer normalen Schaltfunktion ausgebildet. D.h. die Schalteinheiten dienen zum bedarfsweisen Zu- und Abschalten des jeweiligen Strompfades und ergänzend auch zur Absicherung.

Zur Detektion eines elektrischen Stromes und/oder eines Überstromes weist jede Schaltzelle gemäß einer bevorzugten Ausgestaltung ein Strommesselement auf. Hierzu ist beispielsweise das Strommesselement in den Halbleiterschalter nach Art eines bekannten Sensor-Feldeffekttransistors (SenseFET) integriert. Alternativ weist die Schaltzelle zusätzlich zu dem Halbleiterschaltelement ein Strommesselement, beispielsweise ein Shunt auf.

Zweckdienlicherweise ist eine Steuereinheit, beispielsweise ein Mikrocontroller vorgesehen, die derart eingerichtet und ausgebildet ist, dass im Betrieb der Schaltvorrichtung oder einer Vorrichtung, in die die Schaltvorrichtung eingebaut ist jeweils ein innerhalb einer Schalteinheit fließender elektrischer Strom erfasst wird. D.h., dass jeweils der Strom eines an die Schaltvorrichtung angeschlossenen Strompfades erfasst wird. Bei einem Überschreiten eines Stromschwellwertes wird die Schalteinheit von der Steuereinheit angesteuert, deren fließender Strom den Stromschwellwert überschreitet. Durch das Ansteuern wird der Strompfad getrennt und somit vor einem Überstrom geschützt. Die Ansteuerung sowie die prozesstechnischen Abläufe innerhalb der Steuereinheit können sowohl digital als auch analog erfolgen. Eine Auswahl, ob eine analoge oder digitale Ansteuerung erfolgt, sowie die Vorgabe des Stromschwellwertes erfolgt beispielsweise anwendungsspezifisch im Rahmen der Fertigung oder der Konfiguration der Schaltvorrichtung.

In diesem Zusammenhang ist die Steuereinheit beispielsweise als eine Kombination aus dem bereits erwähnten Strommesselement und der Gate-Steuereinheit anzusehen. Folglich kann alternativ die Stromerfassung auch in und/oder mittels der Steuereinheit erfolgen.

Alternativ oder ergänzend weist die Schaltvorrichtung und insbesondere die Steuereinheit zusätzliche Komponenten und/oder Funktionen auf, wie beispielsweise eine Not-Aus-Funktion.

Gemäß einer alternativen Ausgestaltung sind zwischen benachbarten Schaltzellen Schalter, beispielsweise Halbleiterschalter zum reversiblen Trennen der Leiter angeordnet. Der Vorteil dieser alternativen Ausgestaltung ist in der reversiblen Trennung der Leiter und somit einer Fähigkeit zu einer "Neukonfiguration" der Schaltvorrichtung zu sehen. Somit ist die Schaltvorrichtung grundsätzlich an geänderte Anforderungen anpassbar.

Speziell um die Medienbeständigkeit der Schaltvorrichtung zu erhöhen, sind die Schalteinheiten gemäß einer zweckdienlichen Ausgestaltung mit einer Vergussmasse umgossen. Insbesondere sind sämtliche Schalteinheiten auf dem Träger gemeinsam umgossen. Alternativ wird beispielsweise im Rahmen der Endkonfektionierung der Schaltvorrichtung ein Schutzlack auf die Schalteinheiten aufgetragen.

Zweckdienlicherweise ist die Schaltvorrichtung in einem Gehäuse angeordnet oder integriert. Das Gehäuse ist vorzugsweise umgossen oder umspritzt, d.h. von einer Guss- oder Spritzmasse abdichtend umgeben. Speziell handelt es sich bei dem Gehäuse um eine Sicherungsbox. Hierbei weist das Gehäuse zumindest einen eingehenden Strompfad sowie beispielsweise zumindest einen ausgehenden Strompfad auf, der durch die Schaltvorrichtung abgesichert ist. Weiterhin weist das Gehäuse hierbei beispielsweise einen Anschluss für einen Mikrocontroller auf, der vorliegend als Steuereinheit dient.

Insbesondere ist die Schaltvorrichtung in einem Kraftfahrzeug, beispielsweise als Sicherungselement angeordnet.

Ausführungsbeispiele der Erfindung werden nachfolgend anhand der Figuren näher erläutert. Diese zeigen teilweise in stark vereinfachten Darstellungen:
- Fig. 1: eine Draufsicht einer schematisch skizzierten Schaltvorrichtung im Ausgangszustand,
- Fig. 2: eine Draufsicht der schematisch skizzierten Schaltvorrichtung im endkonfektionierten Zustand sowie
- Fig. 3: ein grob skizzierter Aufbau eines Gehäuses mit integrierter Schaltvorrichtung.

In den Figuren sind gleichwirkende Teile mit den gleichen Bezugszeichen dargestellt.

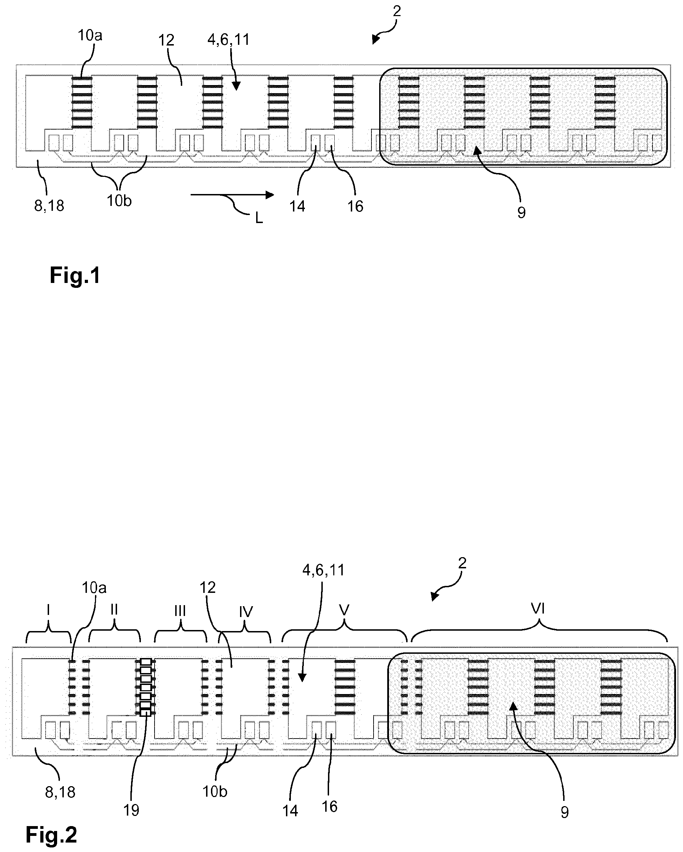

Fig. 1 zeigt eine schematisch dargestellte und als Sicherungsvorrichtung ausgebildete Schaltvorrichtung 2 im Ausgangszustand. Unter Ausgangszustand wird vorliegend speziell verstanden, dass die Schaltvorrichtung 2 (noch) nicht anwendungsspezifisch konfiguriert wurde. Es handelt sich also um ein standardisiertes Zwischenprodukt.

Im Ausführungsbeispiel weist die Schaltvorrichtung 2 zehn Schaltzellen 4 auf. Die Schaltzellen 4 weisen jeweils Halbleiterschaltelemente 6, im Ausführungsbeispiel Transistoren auf. Alternativ sind die Schaltzellen 4 zur Ausbildung der Sicherungsvorrichtung als herkömmliche Schmelzsicherungen ausgebildet. Die Schaltzellen 4 sind hardwaretechnisch seriell, also in einer Längsrichtung L betrachtet hintereinander, auf einem Träger 8, beispielsweise einer Leiterplatine angeordnet, beispielsweise aufgelötet.

Weiterhin sind jeweils benachbarte Schaltzellen 4 miteinander über elektrische Leiter 10a verbunden. Die Leiter 10a sind im Ausführungsbeispiel mittels Bonddrähten realisiert.

Zudem weisen die Schaltzellen 4, insbesondere die Halbleiterschaltelemente 6 jeweils einen Drain-Anschluss 12, einen Gate-Anschluss 14 sowie einen Sensor-Anschluss 16 auf. Weiterhin weisen die Schaltzellen 4 jeweils einen Source-Anschluss 18 auf, der im Ausführungsbeispiel durch den Träger 8 realisiert ist. Der Sensor-Anschluss 16 dient im Ausführungsbeispiel im Betrieb der Schaltvorrichtung 2 einer Übermittlung eines erfassten elektrischen Stromes, der durch die jeweilige Schaltzelle 4 fließt. Die Halbleiterschaltelemente 6 sind hierzu im Ausführungsbeispiel als bereits bekannte Sensor-Feldeffekttransistoren (SenseFET) ausgebildet und weisen ein Strommesselement 11 auf, welches innerhalb der Schaltzelle 4 parallel zu dem Halbleiterschaltelement 6 geschaltet ist (hier nicht dargestellt).

Weiterhin sind ebenfalls jeweils die Drain-Anschlüsse 12, die Gate-Anschlüsse 14 sowie die Sensor-Anschlüsse 16 benachbarter Schaltzellen 4 untereinander mit elektrischen Leitern 10b verbunden.

Die Schaltzellen 4 sind jeweils zum Schalten eines vorgegebenen Wertes eines elektrischen Stroms ausgelegt. Im Ausführungsbeispiel sind die Schaltzellen 4 jeweils zu einem Schalten eines elektrischen Stromes mit einem Maximalwert von 5A ausgelegt. D.h. die Schaltvorrichtung 2 ist insgesamt zu einem Schalten eines Gesamtstromes mit einem Wert von maximal 50A ausgelegt.

Zur anwendungsspezifischen Konfiguration der Schaltvorrichtung 2 sind die elektrischen Leiter 10a, b mechanisch trennbar. D.h. Die elektrischen Leiter 10a, b werden im Rahmen der Konfiguration der Schaltvorrichtung 2 getrennt und die Schaltzellen 4 somit in eine Anzahl an Schalteinheiten 20 (vgl. Fig. 2) unterteilt.

Speziell um die Medienbeständigkeit der Schaltvorrichtung 2 zu erhöhen, sind die Schaltzellen 4 auf dem Träger 8 gemeinsam von einer Vergussmasse 9 umgeben, insbesondere umgossen oder umspritzt. Im Ausführungsbeispiel gemäß Fig. 1 ist die Vergussmasse 9 aus Darstellungszwecken lediglich bis in etwa zur Hälfte der Schaltvorrichtung 2 dargestellt. Im endkonfektionierten Zustand überdeckt die Vergussmasse 9 jedoch alle Schaltzellen 4 vorzugsweise vollständig. Bei der Vergussmasse 9 handelt es sich alternativ um einen Schutzlack.

Fig. 2 zeigt die Schaltvorrichtung 2 in einem endkonfektionierten Zustand, also in einem Zustand, in dem sie anwendungsspezifisch konfiguriert wurde. Zur Konfiguration wurden, wie bereits erwähnt, die Leiter 10a, b zwischen vereinzelten benachbarten Schaltzellen 4 durchtrennt. Im Ausführungsbeispiel gemäß Fig. 2 sind die zehn Schaltzellen 4 in sechs Schalteinheiten (I, II, III, IV, V, VI) unterteilt. Die Trennung der Leiter 10a, b erfolgt beispielsweise mittels eines Laser-Cutting Verfahrens.

Aufgrund dessen, dass jeweils eine Schaltzelle 4 zu einem Schalten eines Stromes mit einem Maximalwert von 5A ausgelegt ist, gliedert sich der maximal schaltbare Stromwert von 50A der Schaltvorrichtung 2 wie folgt auf die sechste Schalteinheiten (I, II, III, IV, V, VI) auf:
I - IV: jeweils 5A
V: 10A
VI: 20A

D.h., dass die sechste Schalteinheit (VI) beispielsweise zu einem Schalten von einem Strom bis maximal 20A ausgelegt ist. Dies wird dadurch erreicht, dass die einzelnen Schaltzellen 4 der sechsten Schalteinheit (VI) parallel geschaltet werden, derart, dass sich beispielsweise ein durch eine abzusichernden Last fließender Strom auf die vier Schaltzellen 4 der Schalteinheit (VI) aufteilt. Auf eine Darstellung der Verschaltung der Schaltvorrichtung 2 mit einer Anzahl an Lasten wurde an dieser Stelle aus Gründen der Vereinfachung verzichtet.

Zudem sind in Fig. 2 zu Darstellungszwecken die Leiter 10a zwischen der Schalteinheit II und der Schalteinheit III mittels Schaltern 19, beispielsweise Halbleiterschaltern realisiert. Hierdurch ist beispielsweise ein "Neukonfiguration" der einzelnen Schalteinheiten 20 ermöglicht, da die Trennung der Leiter 10a,b reversibel mittels der Schalter 19 erfolgt.

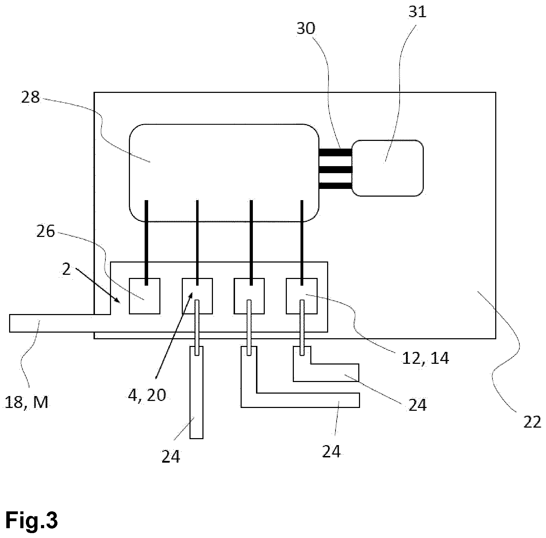

Fig. 3 zeigt die in ein Gehäuse 22 integrierte Schaltvorrichtung 2. Bei dem Gehäuse 22 handelt es sich im Ausführungsbeispiel um ein umspritztes oder umgossenes Gehäuse 22. Die in das Gehäuse 22 integrierte Schaltvorrichtung 2 weist vier Schalteinheiten 20 mit jeweils einer Schaltzelle 4 auf. Drei der vier Schalteinheiten 20 sind an jeweils einen Strompfad 24 angeschlossen. Die Strompfade 24 werden auch als Lastpfade bezeichnet. Im Ausführungsbeispiel sind die Strompfade 24 jeweils an den Drain-Anschluss 12 der jeweiligen Schaltzelle 4 angeschlossen. Die jeweiligen Source-Anschlüsse 18 der Schaltzellen 4 sind gemeinsam an ein gemeinsames Potential, im Ausführungsbeispiel an das Massepotential M angeschlossen.

Im Ausführungsbeispiel ist eine der vier Schaltzellen 4 ist als eine Blindzelle 26 ausgebildet. D.h. an die Blindzelle 26 ist trotz des endkonfektionierten Zustands der Schaltvorrichtung 2 kein Strompfad 24 angeschlossen. Die Blindzelle 26 dient einer nachgerüsteten Verbindung mit einem Strompfad 24 bei Bedarf.

In das Gehäuse 22 ist weiterhin eine Steuereinheit 28 integriert. Die Steuereinheit 28 ist mit den Schalteinheiten 20 und insbesondere mit dem Gate-Anschluss 14 einer jeweiligen Schaltzelle 4 elektrisch verbunden, beispielsweise drahtgebunden. Weiterhin weist die Steuereinheit 28 Anschlüsse 30, beispielsweise Leiterbahnen, beispielsweise für eine Mikrocontrollereinheit 31 auf. Alternativ kann die Mikrocontrollereinheit 31 auch außerhalb des Gehäuses 22 angeordnet sein oder weiter alternativ durch die Steuereinheit 28 ausgebildet sein. Alternativ können mehrere Microcontrollereinheiten 31 im Gehäuse 22 und/oder außerhalb des Gehäuses 22 und/oder in einer Microcontrollereinheit 31 vorhanden sein. Eine Micorcontrollereinheit 31 weist zumindest einen Microcontroller auf. Alternativ kann die Steuereinheit 28 und/oder die Microcontrollereinheit 31 als ein Netzwercknoten ausgebildet sein. Alternativ können Bestandteile des beschriebenen Aufbaus beispielsweise mit weiteren Systemen kommunizieren. Beispielsweise kann die Kommunikation drahtgebunden und/oder drahtlos erfolgen.

Mit Hilfe der Mikrocontrollereinheit 31 wird beispielsweise der fließende Strom eines jeden Strompfades 24 erfasst und mit einem Schwellwert verglichen. Übersteigt zumindest ein fließender Strom eines Strompfades 24 diesen Schwellwert, so übermittelt der Mikrocontroller ein Signal an die Steuereinheit. Die Steuereinheit steuert anschließend die Schalteinheit 20 des betroffenen Strompfades 24 an, sodass der betroffene Strompfad 24 aufgetrennt wird.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebenen Einzelmerkmale auch auf andere Weise miteinander kombinierbar, ohne den Gegenstand der Erfindung zu verlassen.

### Bezugszeichenliste

- 2: Schaltvorrichtung
- 4: Schaltzelle
- 6: Halbleiterschaltelement
- 8: Träger
- 9: Vergussmasse
- 10a,b: elektrischer Leiter
- 11: Strommesselement
- 12: Drain-Anschluss
- 14: Gate-Anschluss
- 16: Sensor-Anschluss
- 18: Source-Anschluss
- 19: Schalter
- 20: Schalteinheit
- 22: Gehäuse
- 24: Strompfad
- 26: Blindzelle
- 28: Steuereinheit
- 30: Anschluss
- 31: Microcontrollereinheit

- L: Längsrichtung
- M: Massepotential

## Patentansprüche

1. Elektrische Schaltvorrichtung (2), die in einem endkonfektionierten Zustand mehrere elektronische Schalteinheiten (20) zum Schalten jeweils eines Strompfades (24) aufweist, wobei jede Schalteinheit (20) zumindest eine elektronische Schaltzelle (4) aufweist und alle Schaltzellen (4) der Schalteinheiten (20) auf einem Träger (8) angeordnet sind,
**dadurch gekennzeichnet, dass** in einem Ausgangszustand alle Schaltzellen (4) zunächst untereinander über elektrische Leiter (10a, b) verbunden sind und zur Ausbildung der Schalteinheiten (20) für den endkonfektionierten Zustand bestimmte Leiter (10a, b) zwischen Schalteinheiten (20) unterbrochen sind, wobei zumindest eine der Schalteinheiten (20) mehrere Schaltzellen (4) aufweist.

2. Schaltvorrichtung (2) nach Anspruch 1,
wobei jede Schaltzelle (4) zum Schalten eines festgelegten Maximalstromwerts ausgelegt ist, wobei bevorzugt jede Schaltzelle (4) zum Schalten eines identischen Maximalstromwerts ausgelegt ist.

3. Schaltvorrichtung (2) nach einem der vorhergehenden Ansprüche,
wobei zumindest eine der Schalteinheiten (20) mehrere parallel geschaltete Schaltzellen (4) aufweist.

4. Schaltvorrichtung (2) nach einem der vorhergehenden Ansprüche,
die mehrere Schalteinheiten (20) aufweist, die eine unterschiedliche Zahl an Schaltzellen (4) aufweist.

5. Schaltvorrichtung (2) nach einem der vorhergehenden Ansprüche,
die zusätzliche Schaltzellen (4) als Blindzellen (26) aufweist, die nicht mit einem Strompfad (24) verbunden sind.

6. Schaltvorrichtung (2) nach einem der vorhergehenden Ansprüche,
wobei die Schaltzellen (4) als Halbleiterschaltelemente (6) ausgebildet sind und mehrere unterschiedliche Arten von Anschlüsse (12,14,16,18) aufweisen, wobei im Ausgangszustand die Anschlüsse (12,14,16,18) gleicher Art miteinander über die Leiter (10a,b) verbunden sind.

7. Schaltvorrichtung (2) nach einem der vorhergehenden Ansprüche,
die als eine Sicherungsvorrichtung ausgebildet ist zur Absicherung der Strompfade (24).

8. Schaltvorrichtung (2) nach dem vorhergehenden Anspruch,
wobei jede Schaltzelle (4) ein Strommesselement (11) aufweist.

9. Schaltvorrichtung (2) nach einem der vorhergehenden Ansprüche, wobei eine Steuereinheit (28) vorgesehen ist, die derart eingerichtet und ausgebildet ist, dass im Betrieb jeweils ein innerhalb eines Strompfades (24) fließender elektrischer Strom durch die jeweilige Schalteinheit (20) erfasst wird und bei einem Überschreiten eines Stromschwellwertes die Schalteinheit (20) des Strompfades (24) angesteuert wird, dessen elektrischer Strom den Schwellwert übersteigt und durch das Ansteuern der Strompfad (24) getrennt wird.

10. Schaltvorrichtung (2) nach einem der vorhergehenden Ansprüche, wobei zwischen benachbarten Schaltzellen (4) Schalter (19) zum reversiblen Trennen der Leiter (10a,b) angeordnet sind.

11. Schaltvorrichtung (2) nach einem der vorhergehenden Ansprüche, wobei die Schalteinheiten (20) von einer Vergussmasse (9) umgossen sind.

12. Schaltvorrichtung (2) nach einem der vorhergehenden Ansprüche,
die in einem insbesondere umgossenen Gehäuse (22) integriert ist mit zumindest einem eingehenden Strompfad (24) und mit mehreren ausgehenden Strompfaden (24).

13. Schaltvorrichtung (2) nach einem der vorhergehenden Ansprüche,
die in einem Kfz angeordnet ist.

14. Verfahren zur Herstellung einer Schaltvorrichtung (2) nach einem der vorhergehenden Ansprüche,
bei dem mehrere elektronische Schalteinheiten (20) auf einem Träger (8) angeordnet werden und jede Schalteinheit (20) jeweils zumindest eine elektronische Schaltzelle (4) aufweist, wobei alle Schaltzellen (4) zunächst untereinander über elektrisch Leiter (10a,b) verbunden werden und zur Ausbildung der Schalteinheiten (20) für den endkonfektionierten Zustand bestimmte Leiter (10a,b) zwischen benachbarten Schalteinheiten (20) unterbrochen werden.

## Claims

1. An electrical switching device (2) which, in a fully assembled state, has multiple electronic switching units (20) for switching a current path (24) each, wherein each switching unit (20) has at least one electronic switching cell (4), and all the switching cells (4) of the switching units (20) are arranged on a carrier (8),
wherein, in an initial state, all the switching cells (4) are initially connected among each other via electrical conductors (10a, b), and conductors (10a, b) determined for forming the switching units (20) for the fully assembled state are interrupted between switching units (20), wherein at least one of the switching units (20) has multiple switching cells (4).

2. The switching device (2) according to claim 1,
wherein each switching cell (4) is adapted for switching a set maximum current value, wherein preferably each switching cell (4) is adapted for switching an identical maximum current value.

3. The switching device (2) according to any one of the preceding claims,
wherein at least one of the switching units (20) has multiple switching cells (4) connected in parallel.

4. The switching device (2) according to any one of the preceding claims,
which has multiple switching units (20) having a different number of switching cells (4).

5. The switching device (2) according to any one of the preceding claims,
which has additional switching cells (4) as dummy cells (26) which are not connected to a current path (24).

6. The switching device (2) according to any one of the preceding claims,
wherein the switching cells (4) are designed as semiconductor switching elements (6) and have multiple different types of terminals (12, 14, 16, 18), wherein in the initial state the terminals (12, 14, 16, 18) of a same type are connected to each other via the conductors (10a, b).

7. The switching device (2) according to any one of the preceding claims,
which is designed as a fuse device for protecting the current paths (24).

8. The switching device (2) according to the preceding claim,
wherein each switching cell (4) has a current measuring element (11).

9. The switching device (2) according to any one of the preceding claims,
wherein a control unit (28) is provided which is configured and designed in such a way that, during operation, an electric current flowing within a current path (24) each is being detected by the respective switching unit (20) and, if surpassing a current threshold value, the switching unit (20) of the current path (24) whose electric current exceeds the threshold value is being controlled and the current path (24) is being disconnected by the controlling.

10. The switching device (2) according to any one of the preceding claims,
wherein switches (19) for reversibly disconnecting the conductors (10a,b) are arranged between adjacent switching cells (4).

11. The switching device (2) according to any one of the preceding claims,
wherein the switching units (20) are encapsulated by a potting compound (9).

12. The switching device (2) according to any one of the preceding claims,
which is integrated in an, in particular encapsulated, housing (22) with at least one incoming current path (24) and with multiple outgoing current paths (24).

13. The switching device (2) according to any one of the preceding claims, which is arranged in a motor vehicle.

14. A process for producing a switching device (2) according to any one of the preceding claims,
in which multiple electronic switching units (20) are being arranged on a carrier (8) and each switching unit (20) has at least one electronic switching cell (4) each, wherein all the switching cells (4) are initially being connected among each other via electrical conductors (10a, b), and conductors (10a, b) determined for forming the switching units (20) for the fully assembled state are being interrupted between adjacent switching units (20).

## Revendications

1. Dispositif de commutation électrique (2) qui comporte en un état final de fabrication plusieurs unités de commutation électroniques (20) destinées chacune à la commutation d'un parcours de courant (24), chaque unité de commutation (20) comportant au moins une cellule de commutation électronique (4) et toutes les cellules de commutation (4) des unités de commutation (20) étant disposées sur un support (8),
**caractérisé en ce qu'**en un état initial toutes les cellules de commutation (4) sont d'abord reliées entre elles par des conducteurs électriques (10a, b) et, pour la formation des unités de commutation (20) pour l'état final de fabrication, certains conducteurs (10a, b) sont interrompus entre des unités de commutation (20), au moins une des unités de commutation (20) comportant plusieurs cellules de commutation (4).

2. Dispositif de commutation (2) selon la revendication 1,
dans lequel chaque cellule de commutation (4) est disposée pour la commutation d'une valeur maximale fixée de courant, de préférence chaque cellule de commutation (4) étant disposée pour la commutation d'une valeur maximale identique de courant.

3. Dispositif de commutation (2) selon l'une quelconque des revendications précédentes,
dans lequel au moins une des unités de commutation (20) comporte plusieurs cellules de commutation (4) montées en parallèle.

4. Dispositif de commutation (2) selon l'une quelconque des revendications précédentes,
qui comporte plusieurs unités de commutation (20) qui comportent un nombre différent de cellules de commutation (4).

5. Dispositif de commutation (2) selon l'une quelconque des revendications précédentes,
qui comporte des cellules de commutation (4) supplémentaires en tant que cellules factices (26) qui ne sont pas reliées à un parcours de courant (24).

6. Dispositif de commutation (2) selon l'une quelconque des revendications précédentes,
dans lequel les cellules de commutation (4) sont configurées en tant qu'éléments commutateurs à semi-conducteurs (6) et comportent plusieurs types différents de connexions (12, 14, 16, 18), en l'état initial les connexions (12, 14, 16, 18) de même type étant reliées entre elles par les conducteurs (10a, b)

7. Dispositif de commutation (2) selon l'une quelconque des revendications précédentes,
qui est configuré en tant qu'un dispositif de sécurité, destiné à la protection du parcours de courant (24).

8. Dispositif de commutation (2) selon l'une quelconque des revendications précédentes,
dans lequel chaque cellule de commutation (4) comporte un élément de mesure du courant (11).

9. Dispositif de commutation (2) selon l'une quelconque des revendications précédentes,
dans lequel est prévu une unité de commande (28) qui est configurée et disposée de telle façon qu'en fonctionnement chaque fois un courant électrique circulant au sein d'un parcours de courant (24) est collecté par l'unité de commutation (20) respective et en cas d'un dépassement d'une valeur seuil de courant l'unité de commutation (20) du parcours de courant (24), dont le courant électrique dépasse la valeur seuil, est déclenchée et le parcours de courant (24) est coupé par le déclenchement.

10. Dispositif de commutation (2) selon l'une quelconque des revendications précédentes,
dans lequel entre des cellules de commutation (4) voisines des coupe-circuits (19) sont disposés pour la coupure réversible des conducteurs (10a, b).

11. Dispositif de commutation (2) selon l'une quelconque des revendications précédentes,
dans lequel les unités de commutation (20) sont enrobées par une matière de scellement (9).

12. Dispositif de commutation (2) selon l'une quelconque des revendications précédentes,
qui est intégré dans un boîtier (22) en particulier enrobé, avec au moins un parcours de courant (24) entrant et avec plusieurs parcours de courant (24) sortants.

13. Dispositif de commutation (2) selon l'une quelconque des revendications précédentes,
qui est placé dans un véhicule automobile.

14. Procédé pour la fabrication d'un dispositif de commutation (2) selon l'une quelconque des revendications précédentes,
dans lequel plusieurs unités de commutation électroniques (20) sont disposées sur un support (8) et chaque unité de commutation (20) comporte chaque fois au moins une unité de commutation électronique (4), toutes les cellules de commutation (4) étant d'abord reliée en elles par des conducteurs électriques (10a, b) et, pour la formation des unités de commutation (20) pour l'état final de fabrication, certains conducteurs (10a, b) sont interrompus entre des unités de commutation (20) voisines.
